(19) Europäisches Patentamt
European Patent Office
Office européen des brevets

(11) **EP 2 688 262 A1**

(12) **EUROPEAN PATENT APPLICATION**
published in accordance with Art. 153(4) EPC

(43) Date of publication:
**22.01.2014 Bulletin 2014/04**

(51) Int Cl.:
*H04L 27/38* (2006.01)    *G01S 7/285* (2006.01)
*H04B 1/30* (2006.01)    *H04L 27/00* (2006.01)

(21) Application number: **12758261.7**

(22) Date of filing: **08.03.2012**

(86) International application number:
**PCT/JP2012/055924**

(87) International publication number:
**WO 2012/124586 (20.09.2012 Gazette 2012/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.03.2011   JP 2011055253**

(71) Applicants:
• **Furukawa Electric Co., Ltd.**
**Chiyoda-ku**
**Tokyo 100-8322 (JP)**
• **Furukawa Automotive Systems Inc.**
**Inukami-gun, Shiga 522-0242 (JP)**

(72) Inventors:
• **MATUSHIMA, Sadao**
**Tokyo 100-8322 (JP)**
• **FUKUCHI, Toshihide**
**Tokyo 100-8322 (JP)**
• **TAKAHASHI, Kei**
**Tokyo 100-8322 (JP)**

(74) Representative: **advotec.**
**Patent- und Rechtsanwälte**
**Widenmayerstrasse 4**
**80538 München (DE)**

(54) **QUADRATURE DEMODULATOR**

(57)    Provided is a quadrature demodulator capable of appropriately correct an amplitude error and a quadrature error even with respect to a pulse-modulated signal. In the quadrature demodulator 100, in order to compensate an amplitude error and a quadrature error, the phase adjuster 112 is provided in the local oscillation unit 110, and the quadrature detection error detector 131 and the quadrature detection error compensator 132 are provided in the signal processing unit 130. The quadrature detection unit 120 outputs two sets of I and Q-components of an RF signal using two LO signals that have been phase-shifted by the phase adjuster 112. In the quadrature detection error detector 131, an amplitude error and a quadrature error are calculated using the two sets of I and Q-components. The quadrature detection error compensator 132 compensates a received signal using the amplitude error and the quadrature error.

FIG. 1

EP 2 688 262 A1

**Description**

Technical Field

The present invention relates to a quadrature demodulator used in a wireless communication apparatus or a radar apparatus, and particularly to a quadrature demodulator that detects and corrects an amplitude error and a quadrature error.

Background Art

A radar apparatus transmits a radio wave, receives a signal of the radio wave reflected by an object, and processes the received signal to obtain the positional information of the object such as the distance and angle to the object. There is known a radar apparatus that employs a synchronous detection method for the purpose of improving the receiver sensitivity and the like. In particular, in the case of direct-conversion synchronous detection, a detection method using a quadrature demodulator can be employed for preventing the detection omission of a target which may occur according to phase conditions, or for detecting the relative velocity of an object using Doppler shift.

In an in-phase component (I-component) and a quadrature component (Q-component) output from a quadrature demodulator, an amplitude error and a quadrature error may occur due to the influence of characteristic variation, ambient temperature, power supply voltage characteristics and the like. When such errors occur, if radar signal processing is performed by using an I-component signal and a Q-component signal (collectively referred to as an IQ signal) output from the quadrature demodulator without any change, the amplitude of the received signal may become unstable, and the maximum detectable distance may therefore be shortened. Further, in a radar apparatus that performs relative velocity detection using Doppler shift, a signal having a fake relative velocity appears due to an amplitude error and a quadrature error. Therefore, a warning may be erroneously issued.

On the other hand, also in digital wireless communications, it has been popularly practiced to perform quadrature detection using a quadrature demodulator, and obtain the detected result thereof as a complex signal (IQ signal) in order to demodulate a signal that has been modulated by a digital modulation method. When an amplitude error and a quadrature error occur in a quadrature demodulator used in digital wireless communications, the bit error rate disadvantageously increases.

Patent Literature 1 discloses an amplitude error  compensating device and a quadrature error compensating device as techniques for correcting an amplitude error and a quadrature error in a quadrature demodulator. In Patent Literature 1, for example, the amplitude error compensating device is provided with a power difference calculating section for obtaining, with respect to an in-phase component and a quadrature component of a complex signal obtained by quadrature detection, a difference in power between the in-phase component and the quadrature component of the amplitude-corrected complex signal, and a rotation detecting section for detecting a rotation of a signal point of the amplitude-corrected complex signal.

Citation List

Patent Literature

Patent Literature 1: Japanese Patent No. 4495210

Summary of Invention

Technical Problem

However, the amplitude error compensating device described in Patent Literature 1 cannot correct an amplitude error and a quadrature error in a wireless communication apparatus that does not perform phase modulation, for example, in a wireless communication apparatus based on pulse modulation. Further, also in a radar apparatus based on pulse modulation, since the frequency offset of a received signal and the rotation of a signal point of a complex signal are not unique, the amplitude error compensating device described in Patent Literature 1 cannot correct an amplitude error and a quadrature error.

The present invention has been made in view of the above problem, and is directed to provide a quadrature demodulator capable of appropriately correct an amplitude error and a quadrature error even with respect to a pulse-modulated signal.

Solution to Problem

In order to solve the above problem, a first aspect of a quadrature demodulator of the present invention includes : a local oscillation unit having a local oscillator, the local oscillator oscillating a local oscillation signal of a predetermined frequency; a quadrature detection unit inputting thereto the local oscillation signal output from the local oscillation unit and a predetermined high frequency signal and detecting an in-phase component and a quadrature component of the high frequency signal; and a signal processing unit inputting thereto the in-phase component and the quadrature component from the quadrature detection unit and performing signal processing for detecting predetermined information from the high frequency signal, the quadrature demodulator further includes: a phase adjuster adjusting the phase of the local oscillation signal oscillated by the local oscillator so as to be shifted by the amount of predetermined phase shift; a quadrature detection error detector inputting thereto a first in-phase component and a first quadrature component of the high frequency signal detected by the quadrature detection unit using a first local oscillation signal adjusted by the phase adjuster by the amount of first phase shift and a second in-phase component and a second quadrature component of the high frequency signal detected by the quadrature detection unit using a second local oscillation signal adjusted by the phase adjuster by the amount of second phase shift, and calculating an amplitude error and a quadrature error between the in-phase component and the quadrature component of the high frequency signal from the first in-phase component and the first quadrature component and the second in-phase component and the second quadrature component; and a quadrature detection error compensator performing compensation using the amplitude error and the quadrature error calculated by the quadrature detection error detector.

According to another aspect of the quadrature demodulator of the present invention, the phase adjuster performs the adjustment so that the amount of the first phase shift is zero degree.

According to another aspect of the quadrature demodulator of the present invention, the phase adjuster performs the adjustment so that a difference between the amount of the first phase shift and the amount of the second phase shift is 90 degree.

Another aspect of a quadrature demodulator of the present invention includes: a local oscillation unit having a local oscillator, the local oscillator oscillating a local oscillation signal of a predetermined frequency; first and second quadrature detection units inputting thereto the local oscillation signal output from the local oscillation unit and a predetermined high frequency signal and detecting an in-phase component and a quadrature component of the high frequency signal; and a signal processing unit inputting thereto the in-phase component and the quadrature component from the first and second quadrature detection units and performing signal processing for detecting predetermined information from the high frequency signal, the quadrature demodulator further includes: a signal divider dividing the local oscillation signal oscillated by the local oscillator into a first local oscillation signal and a second local oscillation signal, and applying a predetermined phase difference between the first local oscillation signal and the second local oscillation signal; a quadrature detection error detector inputting thereto a first in-phase component and a first quadrature component of the high frequency signal detected by the first quadrature detection unit using the first local oscillation signal divided by the signal divider and a second in-phase component and a second quadrature component of the high frequency signal detected by the second quadrature detection unit using the second local oscillation signal divided by the signal divider, and calculating an amplitude error and a quadrature error between the in-phase component and the quadrature component of the high frequency signal from the first in-phase component and the first quadrature component and the second in-phase component and the second quadrature component; and a quadrature detection error compensator performing compensation using the amplitude error and the quadrature error calculated by the quadrature detection error detector.

According to another aspect of the quadrature demodulator of the present invention, the signal divider applies a phase difference of 90 degree between the first local oscillation signal and the second local oscillation signal.

According to another aspect of the quadrature demodulator of the present invention, the high frequency signal used for calculating the amplitude error and the quadrature error in the quadrature detection error detector is a leakage signal leaked into the quadrature detection unit from a transmitter unit, the transmitter unit inputting thereto the local oscillation signal from the local oscillation unit to generate a predetermined transmitted signal, and emitting the transmitted signal into space from a transmitter antenna.

According to another aspect of the quadrature demodulator of the present invention, the high frequency signal used for calculating the amplitude error and the quadrature error in the quadrature detection error detector is a received signal obtained in such a manner that a predetermined transmitted signal generated by inputting the local oscillation signal from the local oscillation unit is emitted into space from a transmitter antenna and reflected by a predetermined object, and a reflected wave of the transmitted signal is then received by a receiver antenna.

According to another aspect of the quadrature demodulator of the present invention, the quadrature demodulator further includes a signal path for transmitting the local oscillation signal from the local oscillation unit to one side of the quadrature detection unit to which the high frequency signal is input, wherein the high frequency signal used for calculating the amplitude error and the quadrature error in the quadrature detection error detector is the local oscillation signal input to the quadrature detection unit via the signal path.

A first aspect of a wireless communication apparatus of the present invention includes the quadrature demodulator according to any one of the above aspects.

A first aspect of a radar apparatus of the present invention includes the quadrature demodulator according to any one of the above aspects.

Advantageous Effects of Invention

According to the present invention, it is possible to provide a quadrature demodulator capable of appropriately correcting an amplitude error and a quadrature error even with respect to a pulse-modulated signal.

Brief Description of Drawings

Fig. 1 is a block diagram illustrating the configuration of a radar apparatus that is provided with a quadrature demodulator according to the first embodiment of the present invention.

Fig. 2 is a block diagram illustrating an example of an RF signal used for calculating an amplitude error and a quadrature error in the quadrature demodulator of the first embodiment.

Fig. 3 is a block diagram illustrating another example of the RF signal used for calculating an amplitude error and a quadrature error in the quadrature demodulator of the first embodiment.

Fig. 4 is a block diagram illustrating the configuration of a radar apparatus that is provided with a quadrature demodulator according to the second embodiment of the present invention.

Fig. 5 is a block diagram illustrating the configuration of a radar apparatus that is provided with a quadrature demodulator according to the third embodiment of the present invention.

Description of Embodiments

Quadrature demodulators in preferred embodiments of the present invention will be described in detail with reference to the drawings. Components having the same function are denoted by the same reference symbols throughout the drawings for simplifying illustration and description.

(First Embodiment)

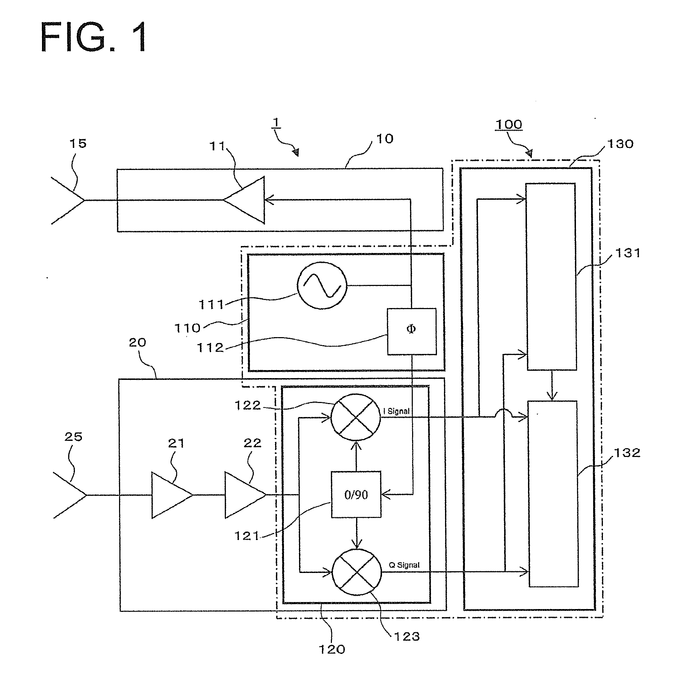

Hereinbelow, a quadrature demodulator according to the first embodiment of the present invention will be described with reference to Fig. 1. Fig. 1 is a block diagram illustrating the configuration of a radar apparatus 1 that is provided with a quadrature demodulator 100 of the present embodiment. In Fig. 1, the quadrature demodulator 100 of the present embodiment is provided with a local oscillation unit 110 which includes a local oscillator 111 and a phase adjuster 112, a quadrature detection unit 120 which includes a phase shifter 121, a first mixer 122 and a second mixer 123, and a signal processing unit 130 which includes a quadrature detection error detector 131 and a quadrature detection error compensator 132.

Further, the radar apparatus 1 is provided with, in addition to the quadrature demodulator 100 of the present embodiment, a transmitter unit 10, a transmitter antenna 15, a receiver unit 20, and a receiver antenna 25. In the transmitter unit 10, a local oscillation signal (LO signal) of a predetermined frequency oscillated by the local oscillator 111 is input, the input signal is amplified by an amplifier 11, and the amplified signal is then emitted into space from the transmitter antenna 15. The transmitted signal emitted from the transmitter antenna 15 is reflected by an object, and then received by the receiver antenna 25. The received signal received by the receiver antenna 25 is amplified by amplifiers 21 and 22. Thereafter, the amplified signal is input to the quadrature detection unit 120, and quadrature-demodulated therein.

In the quadrature detection unit 120, an LO signal output from the local oscillation unit 110 is input together with the received signal. The LO signal input from the local oscillation unit 110 is then input to the phase shifter 121. In the phase shifter 121, a signal to which no phase shift has been applied and a signal to which a phase shift of 90 degree has been applied are output to the first mixer 122 and the second mixer 123, respectively. In each of the first mixer 122 and the second mixer 123, the received signal and the LO signal input from the phase shifter 121 are multiplied. As a result, an in-phase component (I-component) and a quadrature component (Q-component) of the received signal are detected in the first mixer 122 and the second mixer 123, respectively. The detected I-component and Q-component are output to the signal processing unit 130. In the signal processing unit 130, the positional information such as the distance to the object is detected.

The quadrature demodulator 100 of the present embodiment detects an amplitude error and a quadrature error between an I-component and a Q-component which are output to the signal processing unit 130 from the quadrature detection unit 120, and compensates the I-component and the Q-component of the received signal using the detected amplitude error and quadrature error. In order to detect an amplitude error and a quadrature error, the phase adjuster 112 is provided in the local oscillation unit 110, and the quadrature detection error detector 131 is provided in the signal processing unit 130. The phase adjuster 112 can shift the phase of an LO signal output from the local oscillator 111, and output the phase-shifted LO signal to the quadrature detection unit 120. Further, in order to compensate the I-component and Q-component of the received signal, the quadrature detection error compensator 132 is provided in the signal processing unit 130.

First, when detecting an amplitude error and a quadrature error, a predetermined RF signal is input to the quadrature detection unit 120, while two LO signals that have been phase-shifted using the phase adjuster 112 are input to the quadrature detection unit 120. The quadrature detection unit 120 detects two sets of I and Q-components of the RF signal using the respective LO signals of different phases, and outputs the respective two sets of I and Q-components to the quadrature detection error detector 131. The quadrature detection error detector 131 calculates an amplitude error and a quadrature error using the two sets of I and Q-components input from the quadrature detection unit 120.

On the other hand, when compensating an amplitude error and a quadrature error with respect to a received signal, the received signal is input to the quadrature detection unit 120, while an LO signal that has not been phase-shifted by the phase adjuster 112 is input to the quadrature detection unit 120. In the quadrature detection unit 120, the received signal and the LO signal are multiplied to detect an I-component and a Q-component of the received signal. Then, the detected I-component and Q-component are output to the quadrature detection error compensator 132. In the quadrature detection error compensator 132, the previously-detected amplitude error and quadrature error are input from the quadrature detection error detector 131, and the errors of the I-component and the Q-component of the received signal is thereby compensated.

Next, a method for detecting an amplitude error and a quadrature error in the quadrature detection error detector 131 will be described below. Here, a case where an LO signal that has not been phase-shifted and an LO signal that has been phase-shifted by 90 degree by the phase adjuster 112 are output to the quadrature detection unit 120 will be described. The phase adjuster 112 shifts the phases of the respective two LO signals to be output to the quadrature detection unit 120 so that there is a phase difference of 90 degree therebetween.

An RF signal (written as RF) that is used for detecting an amplitude error and a quadrature error is expressed by the following formula (1). Signals derived from the LO signal that has not been phase-shifted by the phase adjuster 112 are expressed by the following formulae (2) and (3). The formula (2) expresses a signal (written as LO_I) to which no phase shift has been applied by the phase shifter 121, and the formula (3) expresses a signal (written as LO_Q) to which a phase shift of 90 degree has been applied by the phase shifter 121.

$$\mathrm{RF = A\,sin\,(\omega t)} \qquad\qquad\qquad (1)$$

$$\mathrm{LO\_I = B\,cos\,(\omega_0 t)} \qquad\qquad\qquad (2)$$

$$\mathrm{LO\_Q = C\,sin\,(\omega_0 t + \alpha)} \qquad\qquad\qquad (3)$$

In the formulae (1) to (3), $\omega$ represents the angular frequency of the RF signal, $\omega 0$ represents the angular frequency of the LO signal, and each of amplitudes A, B and C represents the amplitude including the passage characteristics in a signal path of the each of the RF and LO signals. Accordingly, an amplitude error is expressed by B/C. Further, a phase difference $\alpha$ represents a quadrature error. In the following description, a method for calculating the amplitude error B/C and the quadrature error $\alpha$ will be described.

When the RF signal expressed by the formula (1) and the LO signals expressed by the formulae (2) and (3) are input to the quadrature detection unit 120, an I-component and a Q-component (respectively written as IF_I and IF_Q) of the RF-signal to be output are expressed by the following formulae (4) and (5), respectively.

$$IF\_I = B\cos(\omega_0 t) \times A\sin(\omega t)$$
$$= AB / 2 \{\sin(\omega_0 t + \omega t) - \sin(\omega_0 t - \omega t)\}$$
$$= -AB / 2 \sin(\omega_0 t - \omega t) \qquad (4)$$

$$IF\_Q = C\sin(\omega_0 t + \alpha) \times A\sin(\omega t)$$
$$= -AC / 2 \{\cos(\omega_0 t + \alpha + \omega t) - \cos(\omega_0 t + \alpha - \omega t)\}$$
$$= AC / 2 \cos(\omega_0 t + \alpha - \omega t) \qquad (5)$$

In the formulae (4) and (5), terms ($\omega 0t - \omega t$) and ($\omega 0t + \alpha - \omega t$) obtained by down-converting the RF signal are selected.
Further, when an LO signal that has been phase-shifted by 90 degree by the phase adjuster 112 is input to the quadrature detection unit 120, two signals expressed by the following formulae (6) and (7) are output from the phase shifter 121.

$$LO\_I = B\cos(\omega_0 t + \pi / 2) \qquad (6)$$

$$LO\_Q = C\sin(\omega_0 t + \alpha + \pi / 2) \qquad (7)$$

The quadrature detection unit 120 to which such LO signals are input outputs an I-component and a Q-component expressed by the following formulae (8) and (9), respectively.

$$IF\_I' = B\cos(\omega_0 t + \pi / 2) \times A\sin(\omega t)$$
$$= AB / 2 \{\sin(\omega_0 t + \pi / 2 + \omega t) - \sin(\omega_0 t + \pi / 2 - \omega t)\}$$
$$= -AB / 2 \sin(\omega_0 t + \pi / 2 - \omega t)$$
$$= -AB / 2 \cos(\omega_0 t - \omega t) \qquad (8)$$

$$IF\_Q' = C\sin(\omega_0 t + \alpha + \pi / 2) \times A\sin(\omega t)$$
$$= -AC / 2 \{\cos(\omega_0 t + \alpha + \pi / 2 + \omega t)$$
$$- \cos(\omega_0 t + \alpha + \pi / 2 - \omega t)\}$$
$$= AC / 2 \cos(\omega_0 t + \alpha + \pi / 2 - \omega t)$$
$$= -AC / 2 \sin(\omega_0 t + \alpha - \omega t) \qquad (9)$$

In the formulae (8) and (9), terms ($\omega 0t - \omega t$) and ($\omega 0t + \alpha - \omega t$) obtained by down-converting the RF signal are selected.
The following formula (10) is calculated from the formulae (4) and (8), and the following formula (11) is calculated from the formulae (5) and (9).

$$A B = 2 \sqrt{(I F \_ I)^2 + (I F \_ I')^2} \qquad (10)$$

$$A C = 2 \sqrt{(I F \_ Q)^2 + (I F \_ Q')^2} \qquad (11)$$

Accordingly, the amplitude error B/C can be calculated using the following formula (12).

$$\frac{B}{C} = \frac{\sqrt{(I F \_ I)^2 + (I F \_ I')^2}}{\sqrt{(I F \_ Q)^2 + (I F \_ Q')^2}} \qquad (12)$$

Further, the following formula (13) is obtained from the formula (9), and the following formula (14) is obtained by dividing the formula (4) by the formula (8).

$$\omega o \, t + \alpha - \omega t = \sin^{-1}\left[\frac{-2 \times I F \_ Q'}{A C}\right]$$

$$\alpha = \sin^{-1}\left[\frac{-2 \times I F \_ Q'}{A C}\right] - (\omega o \, t - \omega t) \qquad (13)$$

$$(\omega o \, t - \omega t) = \tan^{-1}\left[\frac{I F \_ I \times \frac{-2}{A B}}{I F \_ I' \times \frac{-2}{A B}}\right] \qquad (14)$$

The quadrature error $\alpha$ can be calculated using the following formula (15) by substituting the formula (11) and the formula (14) into the formula (13).

$$\alpha = \sin^{-1}\left[\frac{-I F \_ Q'}{\sqrt{(I F \_ Q)^2 + (I F \_ Q')^2}}\right] - \tan^{-1}\left[\frac{I F \_ I \times \frac{-2}{A B}}{I F \_ I' \times \frac{-2}{A B}}\right] \qquad (15)$$

In the quadrature detection error compensator 132, it is possible to compensate an amplitude error and a quadrature error with respect to the I-component and the Q-component obtained by quadrature-detecting the received signal received by the receiver antenna 25 by using the amplitude error B/C calculated by the formula (12) and the quadrature error $\alpha$ calculated by the formula (15). More specifically, when a received signal is given as the RF signal expressed by the formula (1), an amplitude error and a quadrature error in the I-component and the Q-component of the received signal are compensated by substituting the amplitude error B/C obtained by the formula (12) and the quadrature error $\alpha$ obtained by the formula (15) into the formula (4) and the formula (5), respectively.

In the above description, the quadrature detection error compensator 132 which compensates an amplitude error and a quadrature error with respect to the received signal is provided in the signal processing unit 130. However, the present invention is not limited thereto, and the quadrature detection error compensator 132 can also be configured using an analog circuit.

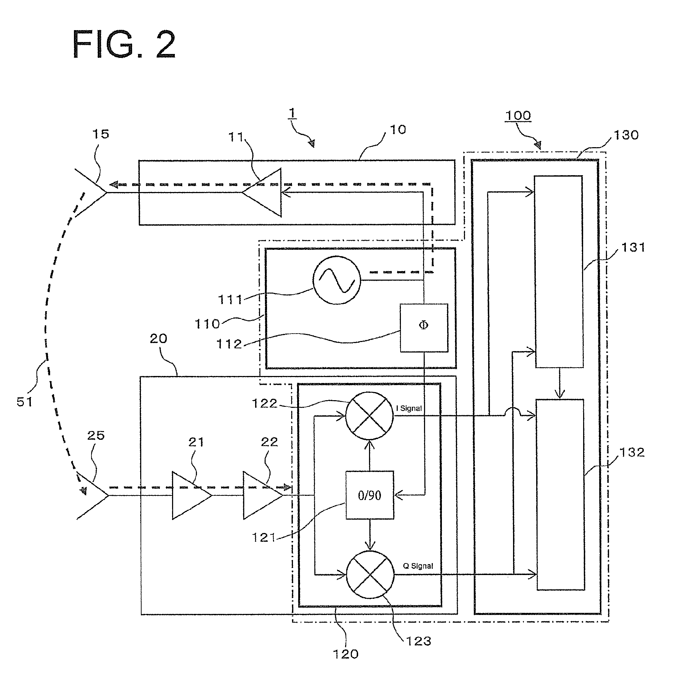

Next, an example of the RF signal used for calculating the amplitude error B/C and the quadrature error a will be described. A first example of the RF signal is illustrated in Fig. 2. An RF signal 51 illustrated in Fig. 2 is a leakage signal that is obtained in such a manner that an LO signal output from the local oscillator 111 passes through the transmitter unit 10, is then leaked from the transmitter antenna 15, then received by the receiver antenna 25, and then input to the quadrature detection unit 120. When the leakage signal from the local oscillator 111 is used as the RF signal, the angular frequency $\omega$ of the RF signal is equal to the angular frequency $\omega0$ of an LO signal oscillated by the local oscillator 111. The method for obtaining the amplitude error B/C and the quadrature error $\alpha$ using the leakage signal from the local oscillator 111 can be applied not only to a radar apparatus, but also to a wireless communication apparatus.

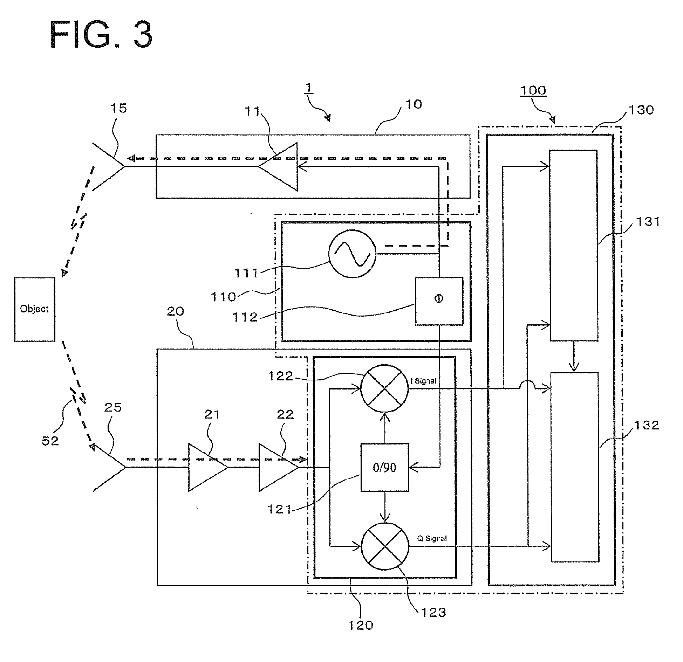

A second example of the RF signal used for calculating the amplitude error B/C and the quadrature error $\alpha$ is shown in Fig. 3. An RF signal 52 shown in Fig. 3 is a received signal that is obtained in such a manner that a transmitted signal that has been generated in the transmitter unit 10 on the basis of an LO signal input from the local oscillator 111 is reflected by an object, and then received by the receiver antenna 25. When the received signal is used as the RF signal, the angular frequency $\omega$ of the RF signal is equal to the angular frequency $\omega0$ of an LO signal oscillated by the local oscillator 111, or is changed from the angular frequency $\omega0$ by the amount of frequency change due to Doppler shift. The method for obtaining the amplitude error B/C and the quadrature error $\alpha$ using the received signal can be applied to a radar apparatus.

(Second Embodiment)

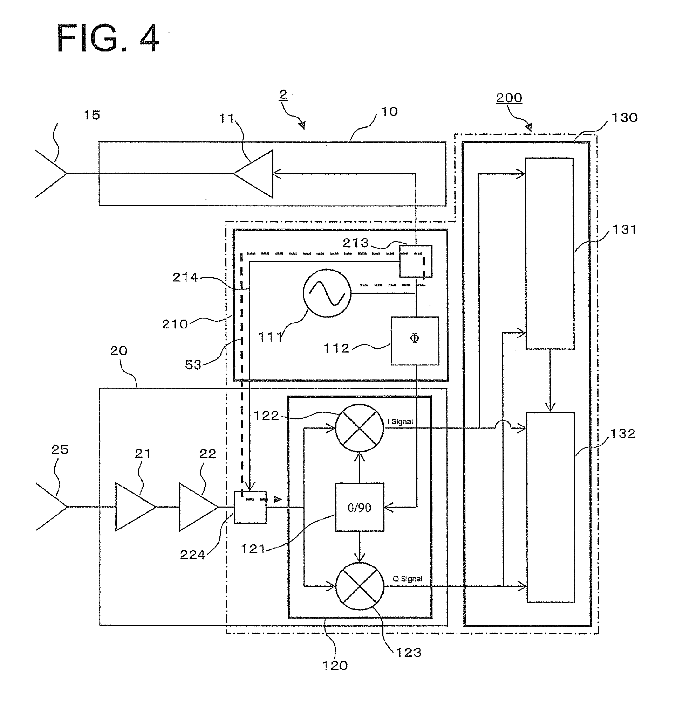

A quadrature demodulator according to the second embodiment of the present invention will be described with reference to Fig. 4. Fig. 4 is a block diagram illustrating the configuration of a radar apparatus 2 that is provided with a quadrature demodulator 200 according to the present embodiment. In Fig. 4, the quadrature demodulator 200 of the present embodiment is further provided with, in addition to the configuration of the quadrature demodulator 100 of the first embodiment, a first coupler 213 which branches an LO signal in the local oscillation unit 210, and a second coupler 224 which is located before the inputting position of a received signal to the quadrature detection unit 120 in the receiver unit 20. The first coupler 213 and the second coupler 224 are connected to each other through a predetermined signal line 214.

In the radar apparatus 2 of the present embodiment configured in the above manner, it is possible to form a signal path where an LO signal output from the local oscillator 111 is branched by the first coupler 213 and the branched signal is transmitted to the second coupler 224 via the signal line 214. The LO signal 53 transmitted to the second coupler 224 is input to the quadrature detection unit 120, and can be used as an RF signal for calculating an amplitude error B/C and a quadrature error $\alpha$. The angular frequency $\omega$ of the RF signal 53 is equal to the angular frequency $\omega0$ of the LO signal oscillated by the local oscillator 111. The method for obtaining the amplitude error B/C and the quadrature error $\alpha$ using the LO signal branched by the local oscillation unit 210 can be applied not only to a radar apparatus, but also to a wireless communication apparatus.

(Third Embodiment)

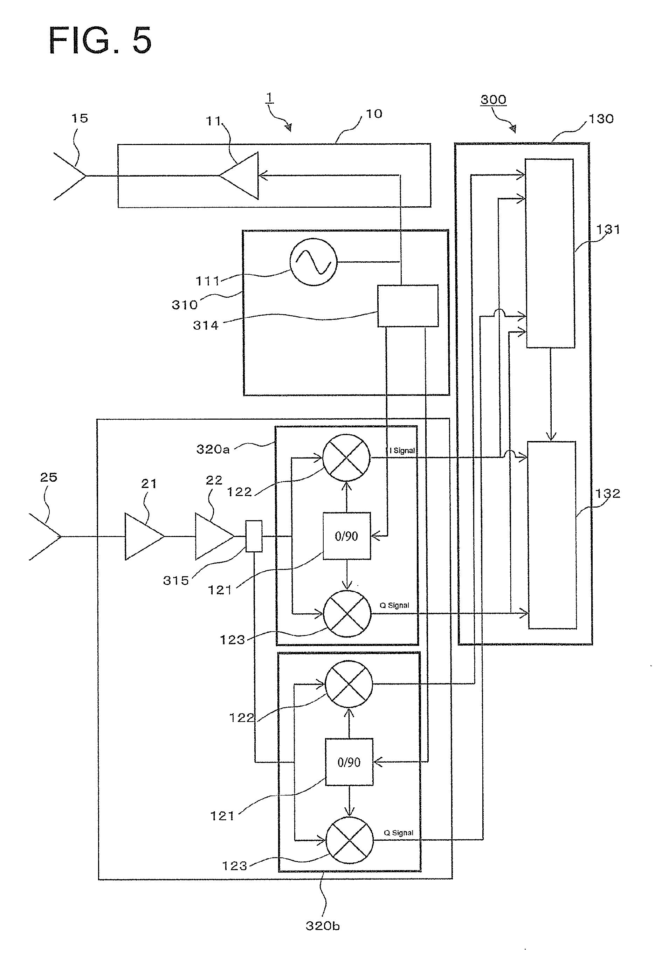

A quadrature demodulator according to the third embodiment of the present invention will be described with reference to Fig. 5. Fig. 5 is a block diagram illustrating the configuration of a radar apparatus 2 that is provided with a quadrature demodulator 300 according to the present embodiment. In Fig. 5, the quadrature demodulator 300 of the present embodiment is provided with two quadrature detection units including a first quadrature detection unit 320a and a second quadrature detection unit 320b. In addition, a signal divider 314 is provided in a local oscillation unit 310. The signal divider 314 is configured to divide an LO signal output from the local oscillator 111 so as to be input to a phase shifter 121 of the first quadrature detection unit 320a and a phase shifter 121 of the second quadrature detection unit 320b. In the signal divider 314, an LO signal to be output to the first quadrature detection unit 320a and an LO signal to be output to the second quadrature detection unit 320b are output so that there is a phase difference of 90 degree applied therebetween.

Further, since it is necessary to input a high frequency signal used for calculating an amplitude error and a quadrature error to both of the first quadrature detection unit 320a and the second quadrature detection unit 320b, a signal divider 315 is provided so as to face the output side of the amplifier 22, for example. The quadrature demodulator 300 of the present embodiment with such a configuration can advantageously obtain the I-component and the Q-component in the above formulae (4) and (5) and the I-component and the Q-component in the above formulae (8) and (9) at the same time. In the present embodiment, when compensating an amplitude error and a quadrature error with respect to a received signal, the received signal is input to the quadrature detection unit 320a, while an LO signal that has not been phase-shifted by the signal divider 314 is input to the quadrature detection unit 320a. In the quadrature detection unit 320a, the received signal and the LO signal are multiplied to detect an I-component and a Q-component of the received signal. Then, the detected I-component and Q-component are output to the quadrature detection error compensator 132. In the quadrature detection error compensator 132, the previously-detected amplitude error and quadrature error are input from the quadrature detection error detector 131, and the errors of the I-component and the Q-component of the received signal is thereby compensated.

As described above, according to the quadrature demodulator of the present invention, it is possible to appropriately correct an amplitude error and a quadrature error even with respect to a pulse-modulated signal. In a pulse radar to which the quadrature demodulator of the present invention is applied, the amplitude of a received signal can be stabilized, thereby making it possible to ensure a desired maximum detectable distance performance. Further, it is possible to avoid the issuance of an erroneous warning by preventing the generation of a signal having a fake relative velocity.

The description in each of the embodiments of the present invention shows an example of the quadrature demodulator according to the present invention, and the present invention is therefore not limited thereto. The detailed configuration and operation of the quadrature demodulator in each of the embodiments can be appropriately modified without departing from the scope of the present invention.

Reference Signs List

| 1, 2 | radar apparatus |
|---|---|
| 10 | transmitter unit |
| 11, 21, 22 | amplifier |
| 15 | transmitter antenna |
| 20 | receiver unit |
| 25 | receiver antenna |
| 51, 52, 53 | RF signal |
| 100, 200, 300 | quadrature demodulator |
| 110, 210, 310 | local oscillation unit |
| 111 | local oscillator |
| 112 | phase adjuster |
| 120 | quadrature detection unit |
| 121 | phase shifter |
| 122 | first mixer |
| 123 | second mixer |
| 130 | signal processing unit |
| 131 | quadrature detection error detector |
| 132 | quadrature detection error compensator |
| 213 | first coupler |
| 214 | signal line |
| 224 | second coupler |
| 320a | first quadrature detection unit |
| 320b | second quadrature detection unit |
| 314 | signal divider |
| 315 | signal divider |

**Claims**

1. A quadrature demodulator comprising: a local oscillation unit having a local oscillator, the local oscillator oscillating a local oscillation signal of a predetermined frequency; a quadrature detection unit inputting thereto the local oscillation signal output from the local oscillation unit and a predetermined high frequency signal and detecting an in-phase component and a quadrature component of the high frequency signal; and a signal processing unit inputting thereto the in-phase component and the quadrature component from the quadrature detection unit and performing signal processing for detecting predetermined information from the high frequency signal, the quadrature demodulator further comprising:

a phase adj uster adjusting the phase of the local oscillation signal oscillated by the local oscillator so as to be shifted by the amount of predetermined phase shift;
a quadrature detection error detector inputting thereto a first in-phase component and a first quadrature component of the high frequency signal detected by the quadrature detection unit using a first local oscillation signal adjusted by the phase adjuster by the amount of first phase shift and a second in-phase component and a second quadrature component of the high frequency signal detected by the quadrature detection unit using a second local oscillation signal adjusted by the phase adjuster by the amount of second phase shift, and calculating an amplitude error and a quadrature error between the in-phase component and the quadrature component of the high frequency signal from the first in-phase component and the first quadrature component and the second in-phase component and the second quadrature component; and

a quadrature detection error compensator performing compensation using the amplitude error and the quadrature error calculated by the quadrature detection error detector.

2. The quadrature demodulator according to claim 1, wherein the phase adjuster performs the adjustment so that the amount of the first phase shift is zero degree.

3. The quadrature demodulator according to claim 1 or 2, wherein the phase adjuster performs the adjustment so that a difference between the amount of the first phase shift and the amount of the second phase shift is 90 degree.

4. A quadrature demodulator comprising: a local oscillation unit having a local oscillator, the local oscillator oscillating a local oscillation signal of a predetermined frequency; first and second quadrature detection units inputting thereto the local oscillation signal output from the local oscillation unit and a predetermined high frequency signal and detecting an in-phase component and a quadrature component of the high frequency signal; and a signal processing unit inputting thereto the in-phase component and the quadrature component from the first and second quadrature detection units and performing signal processing for detecting predetermined information from the high frequency signal, the quadrature demodulator further comprising:

a signal divider dividing the local oscillation signal oscillated by the local oscillator into a first local oscillation signal and a second local oscillation signal, and applying a predetermined phase difference between the first local oscillation signal and the second local oscillation signal;

a quadrature detection error detector inputting thereto a first in-phase component and a first quadrature component of the high frequency signal detected by the first quadrature detection unit using the first local oscillation signal divided by the signal divider and a second in-phase component and a second quadrature component of the high frequency signal detected by the second quadrature detection unit using the second local oscillation signal divided by the signal divider, and calculating an amplitude error and a quadrature error between the in-phase component and the quadrature component of the high frequency signal from the first in-phase component and the first quadrature component and the second in-phase component and the second quadrature component; and

a quadrature detection error compensator performing compensation using the amplitude error and the quadrature error calculated by the quadrature detection error detector.

5. The quadrature demodulator according to claim 4, wherein the signal divider applies a phase difference of 90 degree between the first local oscillation signal and the second local oscillation signal.

6. The quadrature demodulator according to any one of claims 1 to 5, wherein the high frequency signal used for calculating the amplitude error and the quadrature error in the quadrature detection error detector is a leakage signal leaked into the quadrature detection unit from a transmitter unit, the transmitter unit inputting thereto the local oscillation signal from the local oscillation unit to generate a predetermined transmitted signal, and emitting the transmitted signal into space from a transmitter antenna.

7. The quadrature demodulator according to any one of claims 1 to 5, wherein the high frequency signal used for calculating the amplitude error and the quadrature error in the quadrature detection error detector is a received signal obtained in such a manner that a predetermined transmitted signal generated by inputting the local oscillation signal from the local oscillation unit is emitted into space from a transmitter antenna and reflected by a predetermined object, and a reflected wave of the transmitted signal is then received by a receiver antenna.

8. The quadrature demodulator according to any one of claims 1 to 5, further comprising a signal path for transmitting the local oscillation signal from the local oscillation unit to one side of the quadrature detection unit to which the high frequency signal is input,
wherein the high frequency signal used for calculating the amplitude error and the quadrature error in the quadrature detection error detector is the local oscillation signal input to the quadrature detection unit via the signal path.

9. A wireless communication apparatus including the quadrature demodulator according to any one of claims 1 to 8.

**10.** A radar apparatus including the quadrature demodulator according to any one of claims 1 to 8.

# FIG. 1

# FIG. 2

# FIG. 3

# FIG. 4

# FIG. 5

<div align="center">

**INTERNATIONAL SEARCH REPORT**

</div>

| | |
|---|---|
| | International application No. |
| | PCT/JP2012/055924 |

A. CLASSIFICATION OF SUBJECT MATTER
*H04L27/38*(2006.01)i, *G01S7/285*(2006.01)i, *H04B1/30*(2006.01)i, *H04L27/00*
(2006.01)i

According to International Patent Classification (IPC) or to both national classification and IPC

B. FIELDS SEARCHED

Minimum documentation searched (classification system followed by classification symbols)
H04L27/38, G01S7/285, H04B1/30, H04L27/00

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
IEEE Xplore

C. DOCUMENTS CONSIDERED TO BE RELEVANT

| Category* | Citation of document, with indication, where appropriate, of the relevant passages | Relevant to claim No. |
|---|---|---|
| A | JP 4495210 B1 (Panasonic Corp.),<br>30 June 2010 (30.06.2010),<br>fig. 3, 4, 9<br>(Family: none) | 1-10 |
| A | JP 2004-112384 A (Nippon Telegraph and Telephone Corp.),<br>08 April 2004 (08.04.2004),<br>abstract<br>(Family: none) | 1-10 |
| A | JP 2008-8900 A (Matsushita Electric Industrial Co., Ltd.),<br>17 January 2008 (17.01.2008),<br>abstract<br>& US 2007/0285307 A1    & US 2009/0073029 A1 | 1-10 |

☐ Further documents are listed in the continuation of Box C.        ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 31 May, 2012 (31.05.12) | 12 June, 2012 (12.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4495210 B